Europäisches Patentamt

European Patent Office

Office européen des brevets

(11) Publication number: **0 339 727**
**A2**

(12) **EUROPEAN PATENT APPLICATION**

(21) Application number: 89201029.9

(51) Int. Cl.⁴: **H03K 5/08**

(22) Date of filing: 21.04.89

(30) Priority: 27.04.88 GB 8809920
03.03.89 GB 8904899

(43) Date of publication of application:
02.11.89 Bulletin 89/44

(84) Designated Contracting States:
DE FR GB IT SE

(71) Applicant: PHILIPS ELECTRONIC AND
ASSOCIATED INDUSTRIES LIMITED
Philips House 188 Tottenham Court Road
London W1P 9LE(GB)

(84) GB

Applicant: N.V. Philips' Gloeilampenfabrieken
Groenewoudseweg 1
NL-5621 BA Eindhoven(NL)

(84) DE FR IT SE

(72) Inventor: Murray, Bruce
C/O PHILIPS COMPONENTS New Road
Mitcham Junction
Mitcham Surrey CR4 4XY(GB)
Inventor: Bird, Philip Harvey
12 Taylor's Close
Sidcup Kent DA14 6TL(GB)

(74) Representative: Cole, Bernard Victor et al
PHILIPS ELECTRONICS Patents and Trade
Marks Department Centre Point New Oxford
Street
London WC1A 1QJ(GB)

(54) Circuit arrangement for producing a binary signal.

(57) A precoded duobinary signal is applied to first inputs of two voltage comparators (CP1, CP2) whose second inputs receive reference voltages appropriate to required slicing levels. The output of each comparator (CP1, CP2) is applied to respective inputs of an exclusive NOR gate (G) the output of which provides a binary signal dependent on the duobinary signal input. This duobinary input is also applied to peak rectifier circuits (D1, C1; D2, C2) whose outputs are connected to respective ends of a voltage divider (R1, R2, R3) from which the reference voltages for the comparators (CP1, CP2) are derived.

Fig. 1.

## CIRCUIT ARRANGEMENT FOR PRODUCING A BINARY SIGNAL

The present invention relates to a circuit arrangement for producing a binary signal output from a precoded duobinary signal input.

Such a circuit arrangement is described in the article "The Duobinary Technique for High-Speed Data Transmission", by Adam Lender, IEEE Transactions Communication and Electronics, No. 66, May 1963, pages 214-218. In this article a precoded duobinary signal in which each duobinary symbol represents a single bit of information is converted into binary form by means of a full wave rectifier. Whilst such a means for conversion might be satisfactory at relatively low bit rates it is unlikely to give continuous satisfactory results with D-MAC and D2-MAC transmission systems proposed in the European Broadcasting Union (EBU) document Tech. 3258-E "Specification of the systems of the MAC/packet family", October 1986 which contain a burst of data which is duobinary coded at 20.25 MHz or 10.125 MHz respectivley especially as such transmissions are sensitive to interference. A full-wave rectifier converter is unlikely to work satisfactorily in practise at these frequencies as the components used are unlikely to provide the bandwith required.

It is an object of the invention to provide a circuit arrangement for producing a binary signal from a precoded duobinary signal which is less susceptible to interference or other forms of disturbance and is capable of operating at higher frequency rates.

The invention provides a circuit arrangement for producing a binary signal output from a precoded duobinary signal input, characterised in that said arrangement comprises first and second voltage comparators each having a signal input to which said duobinary signal is applied and a reference voltage input, the reference voltage input of said first comparator determining a first slicing level in said applied signal whilst the corresponding input of said second comparator determines a second slicing level in said applied signal, the outputs of said comparators being applied to respective inputs of a gate circuit having a logic function such that the said binary signal can be derived from the gate circuit output, said duobinary signal being additionally applied to first and second peak rectifier circuits for respectively producing voltages determined by the upper and the lower peaks in said duobinary signal which voltages are applied to respective ends of a voltage divider, and means for deriving said first and second reference voltages from said voltage divider.

Such a circuit arrangement has the advantage that by deriving the reference voltages providing the level slicing in the voltage comparators from the duobinary signal itself the slicing action is immune from changes in signal amplitude and level.

Each of the comparators may comprise a differential amplifier where the non-inverting input forms the signal input whilst the inverting input forms the reference voltage input whilst the gate circuit can be an exclusive OR gate or an exclusive NOR gate. Other combinations of differential amplifiers and gate circuits are also possible. Such differential amplifiers may comprise a pair of transistors and the collector of one transistor in a pair of such differential amplifiers may be connected to a common load to form a "wire AND" gate circuit.

Where the circuit arrangement is required to handle binary as well as duobinary signal inputs it may additionally comprise a third voltage comparator having a signal input for receiving a binary input signal and a reference voltage input determining a slicing level in the binary signal which reference voltage input is connected to said voltage divider means for connecting the output of the gate circuit and that of the third comparator to a selector circuit for selecting the appropriate binary output dependent on the nature of the input signal.

The invention also provides a precoded duobinary to binary signal converter comprising first and second differential amplifiers and a gate circuit.

The above and other features of the invention will now be described by way of example with reference to the accompanying drawing in which:-

Figure 1 is a diagram of a circuit arrangment according to the invention,

Figure 2 is a modification of the circuit arrangement of Figure 1, and

Figures 3, 4, 5 and 6 are diagrams of different forms of duobinary to binary converters.

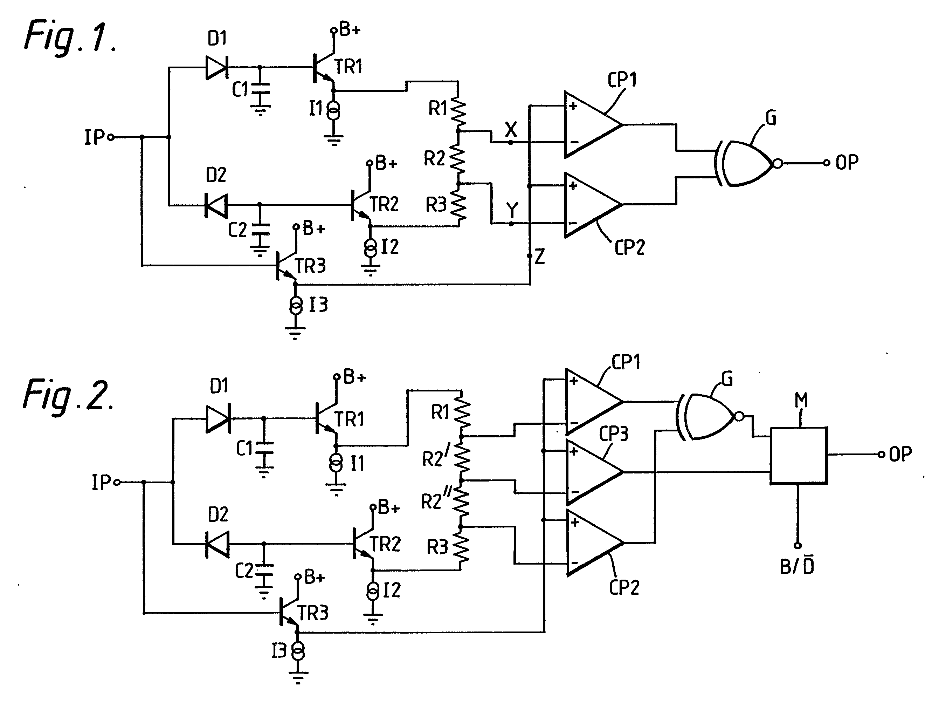

In Figure 1 a duobinary signal is applied to an input IP which is connected to the anode of a diode D1 and the cathode of a further diode D2. The cathode of diode D1 is connected to one terminal of a capacitor C1, whose other terminal is connected to earth, and to the base of an npn transistor TR1 operating as a buffer amplifier. The collector of transistor TR1 is connected to the positive terminal B+ of a voltage supply whose negative terminal is connected to earth whilst the emitter is connected to a current source I1 which is also connected to earth. The anode of diode D2 is connected to one terminal of a capacitor C2, whose other terminal is connected to earth, and to the base of a further transistor TR2. This transistor also operates as a buffer amplifier and has its collector connected to the terminal B + whilst its emitter is connected to a further current source I2 which is also connected to earth.

In operation the diode D1 and capacitor C1 form a peak rectifier circuit rectifying the highest level of the duobinary signal and the resulting voltage is applied to the emitter follower transistor TR1. Similarly the diode D2 and capacitor C2 form a further peak rectifier circuit which rectifies the lowest level of the three level duobinary signal and the resulting voltage is applied to emitter follower transistor TR2. The voltages respectively representing the upper and lower peaks of the duobinary signal are applied from the emitters of the respective transistors TR1 and TR2 to a voltage divider comprising resistors R1, R2 and R3. If resistors R1 and R3 each have a resistive value which is half that of resistor R2 then the voltage at the junction of resistors R1 and R2 will lie halfway between the middle and upper levels of the duobinary signal whilst that at the junction of resistors R2 and R3 will lie halfway between the lower and middle levels of the signal. The voltages at the junctions of these resistors form reference voltages which maintain their relationship with the duobinary input signal even if it is subjected to a change in amplitude or shift in its levels.

The duobinary signal at the input IP is also applied to the base of a third emitter follower transitor TR3 the collector of which is connected to terminal B + and the emitter of which is connected to a current source I3 which is also connected to earth. Transistor TR3 provides a level shift corresponding to that in transistors TR1 and TR2 and its emitter is also connected to a first (CP1) and a second (CP2) voltage comparator each in the form of a differential amplifier, with this signal being applied to the non-inverting inputs ( + ). The inverting input (-) of comparator CP1 receives the upper reference voltage from the junction of resistors R1 and R2 whilst the inverting input (-) of comparator CP2 receives the lower reference voltage from the junction of resistors R2 and R3.

If the three duobinary levels (lower, middle and upper) are represented by 0, 1 and 2 respectively then comparator CP1 will only produce a high output when the input is at level 2 whilst comparator CP2 will produce a high output if the input is either level 1 or level 2. These comparator outputs are applied to respective inputs of a gate circuit G which may have an exclusive OR (EX OR) or exclusive NOR (EX NOR) function which will respectivley produce a high or low output if only one, but not both, of its inputs is high. This if, as shown, gate circuit G is an EX NOR gate it will only produce a high output when the duobinary signal is at level 0 or 2. If the duobinary signal is of the precoded type such that each duobinary symbol represents a single bit of information, such as is described in the above IEEE article by Adam Lender then the output of gate G will represent the binary equivalent of the duobinary input signal. When with such a precoded scheme the duobinary levels 0 or 2 correspond to a binary 1 and duobinary level 1 corresponds to a binary 0 then the output OP from the gate circuit G when it is an EX NOR gate will produce the direct binary equivalent of the duobinary input.

The circuit of Figure 1 is particularly useful in converting the duobinary data in the data burst of a D-MAC packet or D2-MAC packet television signal burst into binary data form. If the input signals were in idealised form then it would also be possible for the circuit to slice a binary signal such as is produced after demodulation of a the data burst of a C-MAC packet television signal. However if such a signal is not in an idealised form and is additionally subjected to noise such that the only satifactory way to slice it is at its mid point. A circuit that will achieve that for a binary input as well as being able to handle a duobinary input is shown in Figure 2 in which figure like reference symbols to those used in Figure 1 indicate like components.

From Figure 2 it will be seen that the peak rectifiers and buffer amplifiers are the same as those in Figure 1. A potential divider is also connected between the emitters of the transistors TR1 and TR2 but this time comprises four resistors R1, $R2^{'}$, $R2^{''}$ and R3 all of which have the same resistive value, i.e. resistors $R2^{'}$ and $R2^{''}$ each have half the resistive value of resistor R2 of Figure 1. Thus the voltage at the junction of resistors $R2^{'}$ and $R2^{''}$ is half the peak-peak voltage at the signal input IP even in the case of amplitude changes and level shifts, the voltages at the other junctions of the potential divider remaining the same as in Figure 1. As with Figure 1 the voltages at the other junctions are applied to comparators CP1 and CP2 together with the signal at input IP which in conjunction with gate circuit G forms the duobinary converter. The reference voltage at the junction of resistors $R2^{'}$, $R2^{''}$ is applied to the inverting input (-) of a third voltage comparator CP3, also in the form of a differential amplifier, the non-inverting input ( + ) of which receives the signal from the input IP, the output of comparator CP3 going high when a binary signal input is in its 1 condition. (In this description the effects of a binary signal input on comparators CP1 and CP2 have been ignored as has the effect of a duobinary signal input on comparator CP3). The outputs from the gate circuit G and voltage comparator CP3 are applied to respective inputs of a multiplexer (switch) M whose operation is controlled from an input B/ $\overline{D}$ such that in the case that a binary signal is being received the output from comparator CP3 is slected whilst in the case that a duobinary signal is being received the output from circuit gate G is selected.

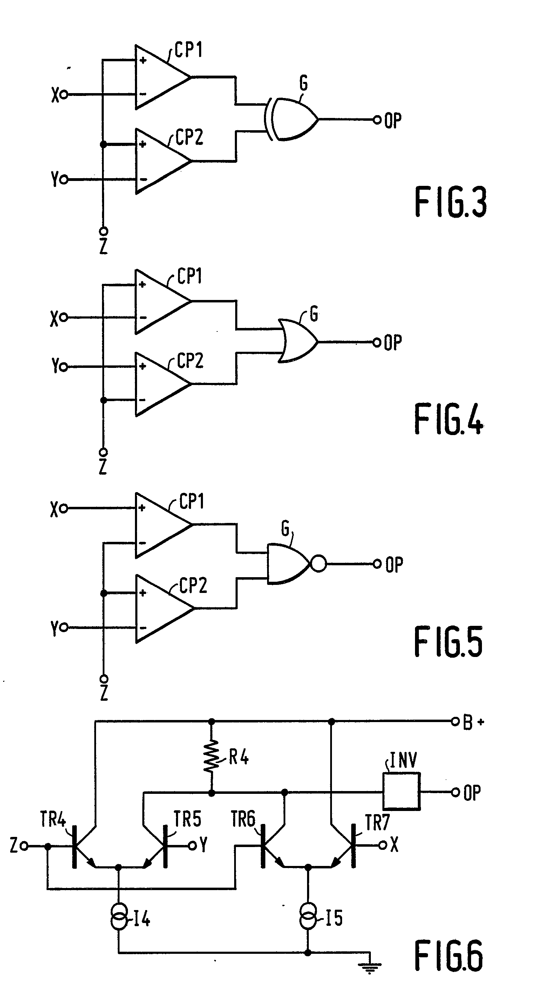

In the embodiments descirbed above for the mentioned precoding scheme the gate circuit G is shown as being an EX NOR gate. If the precoding scheme is opposite to that descirbed, namely duobinary levels 0 or 2 correspond to a binary 0 and duobinary level 1 corresponds to a binary 1, then the gate circuit G may be an EX OR gate as shown in Figure 3 which shows a modification of part of Figure 1 and where X, Y and Z respectively carry the upper reference voltage, the lower reference voltage and the duobinary input signal. Further duobinary to binary converters using other voltage comparator and gate circuit combinations for decoding the duobinary signal when procoded in the first mentioned manner are shown in Figures 4 and 5. In Figure 4 the upper reference voltage (X) is applied to the inverting input (-) of comprator CP1 whilst the lower reference voltage (Y) is applied to the non-inverting input (+) of comparator CP2 whilst the duobinary signal (Z) is applied to the remaining inputs of the comparators CP1 and CP2. In this case the gate circuit G is an OR gate. For Figure 5 the upper reference voltage (X) is applied to the non-inverting input (+) of comparator CP1 and the lower reference voltage (Y) to the inverting input (-) of comparator CP2, the duobinary signal (Z) being applied to the remaining inputs of these comparators CP1 and CP2. The gate circuit G in Figure 5 is a NAND gate. It will be appreciated that other combinations of comparator inputs and gate circuits are possible for the two precoding schemes.

Figure 6 shows in circuit form an additional duobinary to binary converter where the duobinary input (Z) is applied to the bases or npn transistors TR4 and TR6. The upper reference level (X) is applied to the base of an npn transistor TR7 whilst the lower reference level (Y) is applied to the base of a further transistor TR5. Transistors TR4 and TR5 form a differential amplifier with their emitters interconnected and connected through a current source I4 to earth whilst transistor TR4 collector is connected directly to the positive terminal B+ of the voltage supply and that of transistor TR5 is connected to terminal B+ through a load resistor R4. Transistors TR6 and TR7 similarly form a further differential amplifier with their commoned emitters connected through a current source I5 to earth, transistor TR7 collector going directly to terminal B+ whilst that of transistor TR6 is connected to the junction of transistor TR5 collector and resistor R4. This junction is also connected to the input of an inverter INV whose output is connected to the circuit output OP. Transistors TR4 and TR5 and associated connections form the second voltage capacitor CP2 whilst transistors TR6 and TR7 and their connections form the first voltage comparator CP1. The connection of the comparator outputs with a common output resistor R4 forms a "wire-AND" gate configuration. The junction of this resistor with its associated transistors will be LOW when input (Z) is greater than the upper reference level (X) or lower than the lower reference level (Y) and HIGH under the remaining conditions. The inverter INV is required to produce the correct outputs when the precoding scheme is such that duobinary levels 0 and 2 correspond to binary 1 and duobinary level 1 corresponds to binary 0; for the opposite precoding scheme the inverter INV is not required.

From reading the present disclosure, other modifications will be apparent to persons skilled in the art. Such modifications may involve other features which are already known in the design, manufacture and use of circuit arrangements and component parts thereof and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly or any generalisation thereof, whether or not it relates to the same invention as presently claimed in any claim and whether or nct it mitigates any or all of the same technical problems as does the present invention. The applicants hereby give notice that new claims may be formulated to such features and/or combinations of such features during the prosecution of the present application or of any further application derived therefrom.

## Claims

1. A circuit arrangement for producing a binary signal output from a precoded duobinary signal input, characterised in that said arrangement comprises first and second voltage comparators each having a signal input to which said duobinary signal is applied and a reference voltage input, the reference voltage input of said first comparator determining a first slicing level in said applied signal whilst the corresponding input of said second comparator determines a second slicing level in said applied signal, the outputs of said comparators being applied to respective inputs of a gate circuit having a logic function such that the said binary signal can be derived from the gate circuit output, said duobinary signal being additionally applied to first and second peak rectifier circuits for respectively producing voltages determined by the upper and the lower peaks in said duobinary signal which voltages are applied to respective ends of a voltage divider, and means for deriving said first and second reference voltages from said voltage divider.

2. A circuit arrangement as claimed in Claim 1, characterised in that each of said comparators comprises a differential amplifier where the non-inverting input forms the signal input whilst the inverting input forms the reference voltage input whilst said gate circuit is an exclusive OR gate or an exclusive NOR gate.

3. A circuit arrangement as claimed in Claim 1, characterised in that said first and second comparators comprise respective first and second differential amplifiers, the inverting and the non-inverting inputs of said first differential amplifier respectively receiving its reference voltage and the duobinary signal whilst the inverting and the non-inverting inputs of the second differential amplifier respectively receive the duobinary signal and its reference voltage, the gate circuit being an OR gate.

4. A circuit arrangement as claimed in Claim 1, characterised in that said first and second comparators comprise respective first and second differential amplifiers, the inverting and non-inverting inputs of said first differential amplifier respectively receiving the duobinary signal and its reference voltage whilst the inverting and the non-inverting inputs of the second differential amplifier respectively receive its reference voltage and the duobinary signal, the gate circuit being a NAND gate.

5. A circuit arrangement as claimed in Claim 1, characterised in that said first and second comparators each comprise first and second transistors having their emitters commoned, the collector of the first transistor of both comparators being directly connected to a supply voltage while the collectors of the second transistor of both comparators are connected through a common load to said supply voltage, said duobinary signal being applied to the base of the first transistor in the first comprator and to the base of the second transistor in the second comparator while the bases of the remaining transistor in each comparator receive either the first or the second reference voltage.

6. A circuit arrangement as claimed in Claim 1, 2, 3, 4 or 5, characterised in that said arrangement additionally comprising a third voltage comparator having a signal input for receiving a binary input signal and a reference voltage input determining a slicing level in said binary signal which reference voltage input is connected to said voltage divider, means for connecting the output of said gate circuit and that of said third comparator to a selector circuit for selecting the appropriate binary output dependent on the nature of the input signal.

7. A precoded duobinary to binary sigal converter comprising first and second differential amplifiers and a gate circuit as claimed in Claim 2, 3, 4 or 5.

Fig.1.

Fig.2.

EP 0 339 727 A2

1-II-PHB 33450

FIG.3

FIG.4

FIG.5

FIG.6

2-II- PHB 33450